Europäisches Patentamt

European Patent Office

Office européen des brevets

(19)

(11) Veröffentlichungsnummer:

# 0 046 217
## A2

(12) EUROPÄISCHE PATENTANMELDUNG

(21) Anmeldenummer: 81105927.8

(51) Int. Cl.³: **G 11 C 17/00**

(22) Anmeldetag: 27.07.81

(30) Priorität: 14.08.80 DE 3030867

(43) Veröffentlichungstag der Anmeldung: 24.02.82
Patentblatt 82/8

(84) Benannte Vertragsstaaten: DE FR GB

(71) Anmelder: SIEMENS AKTIENGESELLSCHAFT Berlin
und München, Postfach 22 02 61,
D-8000 München 22 (DE)

(72) Erfinder: Giebel, Burkhard, Dipl.-Ing., Asenweg 15,
D-8000 München 83 (DE)
Erfinder: Moormann, Hans, Dr., Dipl.-Phys.,
Ludwig-Moser-Strasse 10, D-8013 Haar (DE)
Erfinder: Schrader, Lothar, Dr.,
Ulrich-von-Hutten-Strasse 44, D-8000 München 83 (DE)

(54) Schaltungsanordnung für einen in Zellen und Spalten organisierten Festwertspeicher zur Vermeidung des Absinkens von Bitleitungspotentialen.

(57) Schaltungsanordnung für einen in Zeilen und Spalten organisierten Festwertspeicher zur Vermeidung des Absinkens von Bitleitungspotentialen unter einen Wert, bei dem an den Bitleitungen ($BL_1$ bis $BL_N$) liegende, mindestens einen Auswahltransistor (beispielsweise $T_1$ bis $T_N$) enthaltende und von einem Bitleitungsdecoder angesteuerte Auswahlschaltungen (16) leitend werden, ohne daß sie vom Bitleitungsdecoder ausgewählt sind. Zur Vermeidung eines unerwünschten Durchschaltens von nicht vom Bitleitungsdecoder angesteuerten Auswahltransistoren ($T_1$ bis $T_N$, $T_A$, $T_B$) liegt dabei an jeweils einer Bitleitung ($BL_1$ bis $BL_N$) jeweils ein Stromeinspeisezweig (15), über den jeder Bitleitung ($BL_1$ bis $BL_N$) ein solcher Strom zugeführt wird, daß für jede der nicht vom Bitleitungsdecoder ausgewählten Auswahlschaltungen (16) die Differenz zwischen mindestens einem Gatepotential der beteiligten Auswahltransistoren ($T_1$, $T_A$; $T_2$, $T_A$; ...; $T_N$, $T_B$) und dem jeweiligen Bitleitungspotential betragsmäßig kleiner als die Einsatzspannung der jeweiligen Auswahltransistoren ($T_1$ bis $T_N$, $T_A$, $T_B$) ist...

0046217

SIEMENS AKTIENGESELLSCHAFT     Unser Zeichen

Berlin und München

                                VPA
                                80 P 1 1 2 8 E

## Schaltungsanordnung für einen in Zeilen und Spalten organisierten Festwertspeicher zur Vermeidung des Absinkens von Bitleitungspotentialen

Die vorliegende Erfindung betrifft eine Schaltungsanordnung für einen in Zeilen und Spalten organisierten Festwertspeicher zur Vermeidung des Absinkens von Bitleitungspotentialen unter einen Wert, bei dem an den Bitleitungen liegende, mindestens einen Auswahltransistor enthaltende und von einem Bitleitungsdecoder angesteuerte Auswahlschaltungen leitend werden, ohne daß sie vom Bitleitungsdecoder ausgewählt sind.

Es ist bekannt, daß bei matrixförmig organisierten, nichtflüchtigen Speichern mit einem beispielsweise 8 Bit breiten Datenausgang die Bitleitungen in 8 Gruppen aufgeteilt werden.

Es ist dabei weiterhin bekannt, daß die Selektion der Bitleitungen aus einer Gruppe über einen Spaltenschalter stattfindet, welcher die ausgewählte Bitleitung über einen Transfertransistor mit dem Leseverstärker des zugehörigen Datenausgangs verbindet. Es sind also in einer Gruppe mindestens so viele Transfertransistoren vorhanden, wie Bitleitungen zur Gruppe gehören. Die vorhandenen 8 Gruppen sind in der Regel gleichartig aufgebaut.

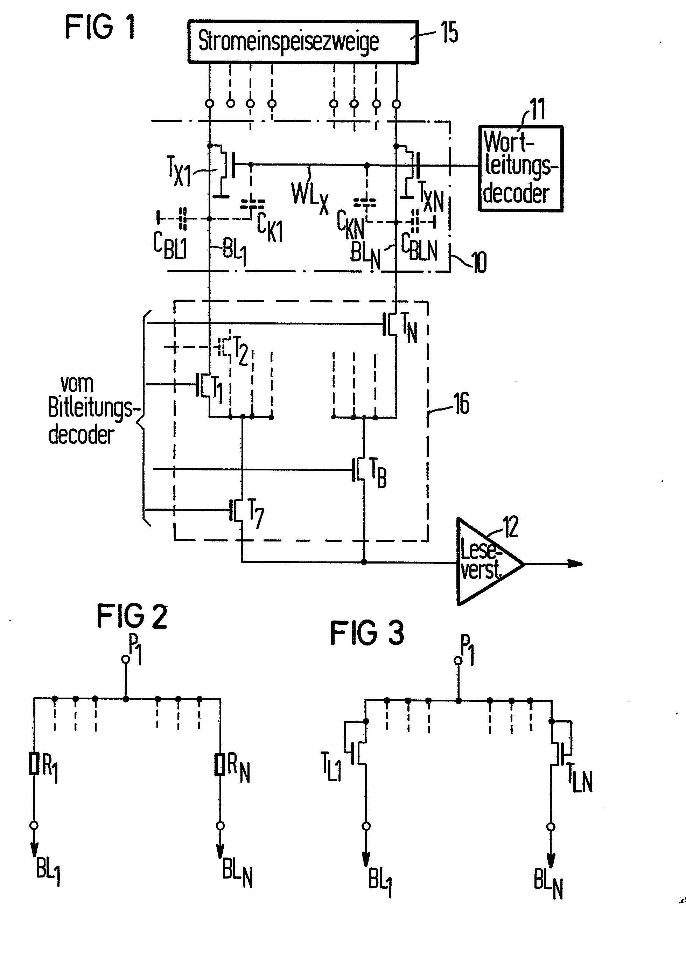

Fig. 1 zeigt in vereinfachter Darstellung ein schematisches Schaltbild eines einem Ein/Ausgang zugeordneten Teils des Zellenfeldes eines Speichers der vorgenannten Art. Ein derartiges Zellenfeld enthält z.B. 2 K Speicherplätze. Die Speicherplätze werden dabei durch jeweils einen MOS-Transistor gebildet, von denen im Speicherfeld

Lz 1 Si/13.8.80

zwei Transistoren $T_{X1}$ und $T_{XN}$ einer Speicherzelle X dargestellt sind. Die Speichertransistoren werden zeilenweise über Wortleitungsdecoder und Wortleitungen angesteuert, von denen für die Zeile X ein Wortleitungsdecoder 11 und eine Wortleitung $WL_X$ dargestellt sind. Die Spaltenansteuerung der Speichertransistoren erfolgt über Bitleitungen, von denen zwei Bitleitungen $BL_1$ und $BL_N$ für die beiden Speichertransistoren $T_{X1}$ und $T_{XN}$ dargestellt sind. Im Zuge der Bitleitungen liegen Auswahltransistoren $T_1$ bis $T_N$, über die jeweils eine Bitleitung mittels Adressen von einem nicht dargestellten Bitleitungsdecoder ausgewählt werden kann. Über weitere Auswahltransistoren $T_A$ und $T_B$ kann noch einmal jeweils eine Untergruppe von Bitleitungen ausgewählt werden. Die Information wird über die entsprechenden Auswahltransistoren auf einen Leseverstärker 12 gegeben und von diesem in nicht näher dargestellter Weise zu einer Verarbeitungselektronik geführt.

Speicherbausteine der vorstehend erläuterten Art haben häufig neben der eigentlichen aktiven Betriebsart, in der Schreib- und Lesevorgänge durchgeführt werden, eine leistungsarme Betriebsart bzw. einen Stromsparbetrieb (power down mode). Diese beiden Betriebsarten sind an sich bekannt und beispielsweise in der DE-OS 27 42 526 beschrieben.

Im Stromsparbetrieb liegen alle Wortleitungen entsprechend der in Fig. 1 dargestellten Wortleitung $WL_X$ auf hohem Potential, das etwa gleich einer Versorgungsspannung $V_{CC}$ ist. Beim Übergang vom Stromsparbetrieb in den aktiven Betrieb geht der Spannungspegel (bis auf eine ausgewählte Wortleitung) gleichzeitig von dem genannten hohen Pegel auf einen tiefen Pegel über. Infolge von unvermeidlichen kapazitiven Kopplungen zwischen den Wortleitungen und den Bitleitungen, von denen in Fig.1 zwei Koppelkapazitäten gestrichelt dargestellt und mit $C_{K1}$ und $C_{KN}$ bezeichnet sind, werden in alle Bitleitungen negative Ladungen eingekoppelt. Die dadurch verursachte Absenkung der Bitleitungsspannung wird vom Verhältnis der Größe der genannten Koppelkapazitäten zur Größe der jeweiligen parasitären Bitleitungskapazitäten ($C_{BC1}$ bis $C_{BCN}$) bestimmt. Der Wert der Bitleitungsspannung am Ende des Übergangs vom Stromsparbetrieb in den aktiven Betrieb wird auch von der Höhe der Bitleitungsspannung zu Beginn des Übergangs bestimmt.

Durch das vorgenannte Absenken der Bitleitungsspannungen kann spannungsmäßig eine Situation entstehen, bei der die Auswahltransistoren $T_1$ bis $T_N$ und/oder $T_A$ und $T_B$ auch bei nicht durch den Bitleitungsdecoder ausgewählten Gates zu leiten beginnen, da die Gate-Source-Spannung der Auswahltransistoren trotz Low-Pegel am Gate größer als die Einsatzspannung wird.

Der vom Leseverstärker (12 in Fig.1) her durch nicht ausgewählte Auswahltransistoren fließende Strom führt dazu, daß der Leseverstärker (12 in Fig.1) eine ausgewählte Bitleitung nur verzögert aufladen und somit auslesen kann. Aufgrund dessen kann die Zugriffszeit beim Übergang in den aktiven Betriebszustand erheblich, z.B. von 400 Nanosekunden auf 1000 Nanosekunden erhöht werden.

Der vorliegenden Erfindung liegt die Aufgabe zugrunde, eine Möglichkeit zur Vermeidung des oben erläuterten Absenkens der Bitleitungspotentiale aufgrund der kapazitiven Kopplung zwischen Wort- und Bitleitungen zu verhindern.

Diese Aufgabe wird bei einer Schaltungsanordnung der eingangs genannten Art erfindungsgemäß durch folgende Merkmale gelöst:

-4-

Jeweils einen an jeweils einer Bitleitung liegenden Stromeinspeisezweig, über den jeder Bitleitung ein solcher Strom zugeführt wird, daß für jede der nicht vom Bitleitungsdecoder ausgewählten Auswahlschaltungen die Differenz zwischen mindestens einem Gatepotential der beteiligten Auswahltransistoren und dem jeweiligen Bitleitungspotential betragsmäßig kleiner als die Einsatzspannung der jeweiligen Auswahltransistoren ist.

Ausgestaltungen des vorstehend definierten Erfindungsgedankens sind in Unteransprüchen gekennzeichnet.

Die Erfindung wird im folgenden anhand von in den Figuren der Zeichnung dargestellten Ausführungsbeispielen näher erläutert. Es zeigt:

Fig. 1 neben den bereits erläuterten Zeilen eines Speicherzellenfeldes eine generelle Darstellung der erfindungsgemäßen Schaltungsanordnung;

Fig. 2 eine erste Ausführungsform von Stromeinspeisezweigen nach Fig. 1;

Fig. 3 eine zweite Ausführungsform von Stromeinspeisezweigen;

Fig.4 eine dritte Ausführungsform von Stromeinspeisezweigen;

Fig. 5 einen Spannungsteiler zur Erzeugung eines vorgegebenen Potentials; und

Fig. 6 eine weitere Ausführungsform eines Kreises zur Erzeugung eines vorgegebenen Potentials.

Gemäß Fig. 1 sind erfindungsgemäß für die Bitleitungen $BL_1$ bis $BL_N$ Stromeinspeisezweige vorgesehen, welche als Block 15 dargestellt sind. Über diese Stromeinspeisezweige ist jeder Bitleitung $BL_1$ bis $BL_N$ ein solcher Strom zuführbar, daß für nicht vom (nicht dargestellten) Bitleitungsdecoder ausgewählte Auswahltransistoren $T_1$ bis $T_N$ bzw. $T_A$ und $T_B$ von Auswahlschaltungen 16 die Potentialdifferenz zwischen den Gates der Auswahltransistoren und der jeweiligen Bitleitung betragsmäßig kleiner als die Einsatzspannung des jeweiligen Auswahltransistors ist.

Gemäß der in Fig. 2 dargestellten Ausführungsform für die Stromeinspeisezweige 15 nach Fig. 1 werden die Stromeinspeisezweige jeweils durch einen Widerstand $R_1$ bis $R_N$ gebildet, der einerseits an der jeweiligen Bitleitung $BL_1$ bis $BL_N$ und andererseits an einem ersten Potential $P_1$ liegt, wobei der jeweilige Widerstandswert und das Potential $P_1$ so gewählt sind, daß ein Stromfluß in nicht ausgewählten Auswahlschaltungen, beispielsweise $T_1$ und $T_A$ nicht auftritt. Die Widerstände $R_1$ bis $R_N$ werden dabei durch Ohm'sche Widerstände gebildet.

Gemäß einer weiteren Ausführungsform ist es auch möglich, daß die Widerstände durch als Last geschaltete MOS-Transistoren gebildet sind. Eine derartige Ausführungsform ist in Fig. 3 dargestellt, wobei als Last geschaltete MOS-Transistoren $T_{L1}$ bis $T_{LN}$ vorgesehen sind. Im übrigen unterscheidet sich diese Ausführungsform der Stromeinspeisezweige nicht von der Ausführungsform nach Fig. 2.

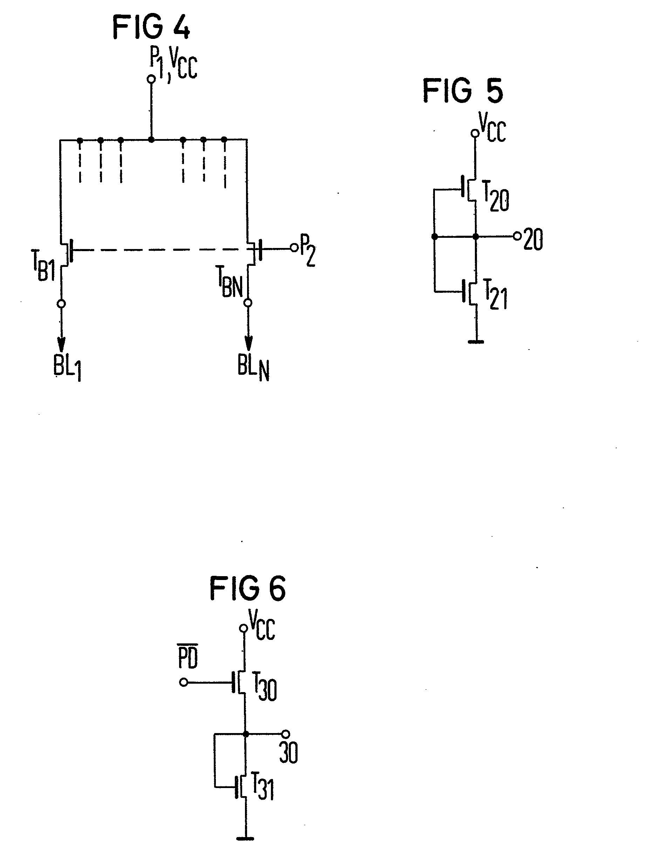

Bei einer in Fig. 4 dargestellten Ausführungsform der Stromeinspeisezweige ist jeweils ein MOS-Transistor $T_{B1}$ bis $T_{BN}$ vorgesehen, die mit ihrer Source-Drain-Strecke einerseits an der jeweiligen Bitleitung ($BL_1$ bis $BL_N$) und andererseits am Potential $P_1$ oder an der Versorgungsspannung $V_{CC}$ liegen und mit ihrem Gate an einem zweiten Potential $P_2$ liegen, wobei die Potentiale so gewählt sind,

- -

daß ein Stromfluß in nicht ausgewählten Auswahlschaltungen, beispielsweise $T_1$, $T_A$, nach Fig. 1 nicht auftritt.

Gemäß einer Möglichkeit können die Potentiale $P_1$ und $P_2$ bei den Ausführungsformen der Stromeinspeisezweige nach den Figuren 2 bis 4 konstant sein, wobei insbesondere das Potential $P_1$, wie in der Ausführungsform nach Fig. 4 dargestellt ist, gleich der Versorgungsspannung $V_{CC}$ sein kann.

Andererseits können das erste und/oder das zweite Potential $P_1$ bzw. $P_2$ auch getaktet werden, so daß sie bei der Umschaltung von der Stromspar-Betriebsart in die aktive Betriebsart wirksam geschaltet werden.

Bei der Ausführungsform der Stromeinspeisezweige nach Fig. 4 ist es insbesondere zweckmäßig, daß die MOS-Transistoren $T_{B1}$ bis $T_{BN}$ von gleichem Typ und gleicher Einsatzspannung wie die Transistoren $T_1$ bis $T_N$ sowie $T_A$ und $T_B$ der Auswahlschaltungen sind und daß das zweite Potential $P_2$ größer als das niedrigste Gate-Potential aller Auswahltransistoren einer jeweils betrachteten, nicht ausgewählten Auswahlschaltung, beispielsweise $T_1$, $T_A$ ist.

Fig. 5 zeigt einen Kreis zur Erzeugung des zweiten Potentials $P_2$ in Form eines aus zwei MOS-Transistoren $T_{20}$ und $T_{21}$ gebildeten Spannungsteilers, in dem der an der Versorgungsspannung $V_{CC}$ liegende Transistor $T_{20}$ als Last geschaltet ist und der an Bezugspotential liegende Transistor $T_{21}$ vom gleichen Typ und annähernd gleicher Einsatzspannung wie die Transistoren $T_{B1}$ bis $T_{BN}$ der Stromeinspeisezweige nach Fig. 4 ist. Das zweite Potential $P_2$ ist dabei an einem Abgriff 20 des Spannungsteilers abnehmbar.

In Halbleiterspeichern der hier in Rede stehenden Art steht in an sich bekannter Weise ein die Stromspar-Betriebsart kennzeichnendes Signal zur Verfügung, das zur Inaktivschaltung bestimmter Kreise des Speichers zur Leistungseinsparung ausgenutzt wird. Dieses Signal, das üblicherweise mit $\overline{PD}$ bezeichnet wird, kann dazu ausgenutzt werden, um die oben erläuterten Stromeinspeisezweige wirksam zu schalten. Eine derartige Möglichkeit ist in Fig. 6 dargestellt. Diese Schaltung enthält einen an Versorgungsspannung $V_{CC}$ liegenden, von dem die Stromspar-Betriebsart kennzeichnenden Signal $\overline{PD}$ angesteuerten ersten MOS-Transistor $T_{30}$ sowie einen zweiten Gate-Drain-verbundenen, in Reihe zum ersten Transistor $T_{30}$ nach Bezugspotential geschalteten MOS-Transistor $T_{31}$. Der zweite Transistor $T_{31}$ ist dabei vom gleichen Typ und annähernd gleicher Einsatzspannung wie die Transistoren $T_{B1}$ bis $T_{BN}$ der Stromeinspeisezweige nach Fig. 4. Am Verbindungspunkt der beiden MOS-Transistoren $T_{30}$ und $T_{31}$ ist das Potential $P_2$ abnehmbar, das in die Gates der Transistoren $T_{B1}$ bis $T_{BN}$ der Stromeinspeisezweige nach Fig. 4 eingespeist wird.

11 Patentansprüche

6 Figuren

<u>Patentansprüche</u>

1. Schaltungsanordnung für einen in Zeilen und Spalten organisierten Festwertspeicher zur Vermeidung des Absinkens von Bitleitungspotentialen unter einen Wert, bei dem an den Bitleitungen liegende, mindestens einen Auswahltransistor enthaltende und von einem Bitleitungsdecoder angesteuerte Auswahlschaltungen leitend werden, ohne daß sie vom Bitleitungsdecoder ausgewählt sind, g e k e n n z e i c h n e t durch jeweils einen an jeweils einer Bitleitung ($BL_1$ bis $BL_N$) liegenden Stromeinspeisezweig (15), über den jeder Bitleitung ($BL_1$ bis $BL_N$) ein solcher Strom zugeführt wird, daß für jede der nicht vom Bitleitungsdecoder ausgewählten Auswahlschaltungen (16) die Differenz zwischen mindestens einem Gatepotential der beteiligten Auswahltransistoren ($T_1$, $T_A$; $T_2$, $T_A$; .....; $T_N$, $T_B$) und dem jeweiligen Bitleitungspotential betragsmäßig kleiner als die Einsatzspannung der jeweiligen Auswahltransistoren ($T_1$ bis $T_N$, $T_A$, $T_B$) ist.

2. Schaltungsanordnung nach Anspruch 1, d a d u r c h g e k e n n z e i c h n e t, daß die Stromeinspeisezweige jeweils durch einen Widerstand ($R_1$ bis $R_N$7 gebildet sind, der einerseits an der jeweiligen Bitleitung ($BL_1$ bis $BL_N$) und andererseits an einem ersten Potential ($_1$) liegt, wobei Widerstandswert und Potential so gewählt sind, daß ein Stromfluß in nicht ausgewählten Auswahlschaltungen ($T_1$, $T_A$; $T_2$, $T_A$; ....; $T_N$, $T_B$) nicht auftritt.

3. Schaltungsanordnung nach Anspruch 1 und 2, d a d u r c h g e k e n n z e i c h n e t, daß die Widerstände ($R_1$ bis $R_N$) ohm'sche Widerstände sind.

4. Schaltungsanordnung nach Anspruch 1 und 2, d a d u r c h g e k e n n z e i c h n e t, daß die Widerstände durch als Last geschaltete MOS-Transistoren ($T_{L1}$ bis $T_{LN}$) gebildet sind.

0046217

5. Schaltungsanordnung nach Anspruch 1, d a d u r c h g e k e n n z e i c h n e t, daß die Stromeinspeisezweige jeweils durch einen MOS-Transistor ($T_{B1}$ bis $T_{BN}$) gebildet sind, die mit ihrer Source-Drain-Strecke einerseits an der jeweiligen Bitleitung ($BL_1$ bis $BL_N$) und andererseits an dem ersten Potential ($P_1$) liegen und mit ihrem Gate an einem zweiten Potential ($P_2$) liegen, wobei die Potentiale so gewählt sind, daß ein Stromfluß in nicht ausgewählten Auswahlschaltungen (s.o.) nicht auftritt.

6. Schaltungsanordnung nach einem der Ansprüche 1 bis 5, d a d u r c h g e k e n n z e i c h n e t, daß das erste und/oder zweite Potential zeitlich konstant ist.

7. Schaltungsanordnung nach einem der Ansprüche 1 bis 6, d a d u r c h g e k e n n z e i c h n e t, daß das erste Potential ($P_1$) gleich der Versorgungsspannung ($V_{CC}$) ist.

8. Schaltungsanordnung nach einem der Ansprüche 1 bis 5, d a d u r c h g e k e n n z e i c h n e t, daß das erste und/oder zweite Potential ($P_1$, $P_2$) getaktet ist.

9. Schaltungsanordnung nach einem der Ansprüche 1 bis 5 und 8, d a d u r c h g e k e n n z e i c h n e t, daß die MOS-Transistoren ($T_{B1}$ bis $T_{BN}$) der Stromeinspeisezweige von gleichem Typ und gleicher Einsatzspannung wie die Auswahltransistoren ($T_1$ bis $T_N$, $T_A$, $T_B$) sind und daß das zweite Potential ($P_2$) größer als das Gate-Potential mindestens eines Auswahltransistors (beispielsweise $T_1$) nicht ausgewählter Auswahlschaltungen (16) ist.

0046217

80 P 1128 E

10. Schaltungsanordnung nach Anspruch 9,
d a d u r c h  g e k e n n z e i c h n e t, daß zur Erzeugung des zweiten Potentials ($P_2$) ein aus zwei MOS-Transistoren ($T_{20}$, $T_{21}$) gebildeter Spannungsteiler vorgesehen ist, in dem ein an der Versorgungsspannung ($V_{CC}$) liegender Transistor ($T_{20}$) als Last geschaltet ist und ein an Bezugspotential liegender Gate-Drain-verbundener Transistor ($T_{21}$) von gleichem Typ und annähernd gleicher Einsatzspannung wie die Transistoren ($T_{B1}$ bis $T_{BN}$) der Stromeinspeisezweige ist, und daß das zweite Potential ($P_2$) am Abgriff des Spannungsteilers abnehmbar ist.

11. Schaltungsanordnung nach Anspruch 9 für einen Festwertspeicher, bei dem eine Umschaltung zwischen einer Stromspar-Betriebsart und einer aktiven Betriebsart möglich ist,
g e k e n n z e i c h n e t  durch einen an Versorgungsspannung ($V_{CC}$) liegenden, von einem die Stromspar-Betriebsart kennzeichnenden Signal ($\overline{PD}$) angesteuerten ersten MOS-Transistor ($T_{30}$) und einen zweiten Gate-Drain-verbundenen, in Reihe zum ersten Transistor ($T_{30}$) nach Bezugspotential geschalteten MOS-Transistor ($T_{31}$) gebildet ist und daß der zweite Transistor ($T_{31}$) vom gleichen Typ und annähernd gleicher Einsatzspannung wie die Transistoren ($T_{B1}$ bis $T_{BN}$) der Stromeinspeisezweige ist, wobei am Verbindungspunkt (30) der beiden Transistoren ($T_{30}$, $T_{31}$) das zweite Potential ($P_2$) abnehmbar ist.

0046217

**FIG 1**

Stromeinspeisezweige — 15

Wortleitungsdecoder — 11

$T_{X1}$   $WL_X$   $T_{XN}$

$C_{K1}$   $C_{KN}$

$C_{BL1}$   $BL_1$   $BL_N$   $C_{BLN}$   10

vom
Bitleitungsdecoder

$T_N$
$T_2$
$T_1$

16

$T_B$

$T_7$

Leseverst. — 12

**FIG 2**

$P_1$

$R_1$   $R_N$

$BL_1$   $BL_N$

**FIG 3**

$P_1$

$T_{L1}$   $T_{LN}$

$BL_1$   $BL_N$

0046217

2/2

**FIG 4**

**FIG 5**

**FIG 6**